Europäisches Patentamt

European Patent Office

Office européen des brevets

(19)

(11) Veröffentlichungsnummer: **0 294 511**
**B1**

(12) **EUROPÄISCHE PATENTSCHRIFT**

(45) Veröffentlichungstag der Patentschrift:
02.05.90

(21) Anmeldenummer: 87114299.8

(22) Anmeldetag: 20.02.86

(60) Veröffentlichungsnummer der früheren Anmeldung
nach Art. 76 EPÜ: 0233967

(51) Int. Cl.⁴: **H03J 7/18**

(54) **Verfahren zum Übertragen einer digitalen Information.**

(43) Veröffentlichungstag der Anmeldung:
**14.12.88 Patentblatt 88/50**

(45) Bekanntmachung des Hinweises auf die Patenterteilung:
**02.05.90 Patentblatt 90/18**

(84) Benannte Vertragsstaaten:
**AT BE CH FR GB IT LI LU NL SE**

(56) Entgegenhaltungen:
**EP-A- 0 092 055**
**EP-A- 0 150 297**
**DE-A- 3 104 845**
**DE-A- 3 208 360**
**DE-A- 3 208 760**
**DE-A- 3 322 987**
**DE-A- 3 432 848**
**DE-A- 3 448 043**

**FUNKSCHAU, Nr. 5, März 1982, Seiten 53-56, München,
DE; P. BAUER: "Mehr als ein Autoradio"**

(73) Patentinhaber: **IRT Inventions Research Technology
Patent-Holding AG, Bahnhofstrasse 22,
CH-8702 Zollikon(CH)**

(72) Erfinder: **Mielke, Jürgen, Dipl.-Ing.,
Floriansmühlstrasse 70, D-8000 München 45(DE)**

(74) Vertreter: **Haft, Berngruber, Czybulka,
Hans-Sachs-Strasse 5, D-8000 München 5(DE)**

## Beschreibung

Die Erfindung bezieht sich auf ein Verfahren gemäß dem Oberbegriff des Patentanspruchs.

Im Rahmen des bekannten Radio-Daten-Systems (RDS), wie es beispielsweise in dem Technischen Dokument Doc.Tech.Nr. 3244 der Europäischen Rundfunk-Union beschrieben ist, ist es u.a. möglich, als Inhalt des auf einen 57 kHz-Hilfsträger aufmodulierten Datensignals eine Liste alternativer Frequenzen (AF) zu übertragen. Diese Information ist insbesondere für den mobilen Empfang gedacht und sagt aus, auf welchen Frequenzen ein bestimmtes Programm von der gleichen Senderkette (z.B. BR 3) ausgestrahlt wird. Dadurch wird es geeignet ausgebildeten Empfängern mit Speicher ermöglicht, diese Liste abzuspeichern und so die Zeit zum Einstellen des Empfängers auf die jeweils optimale Frequez dieser Liste (z.B. nach optimalen Empfangsbedingungen) zu reduzieren. Die Liste ist vereinbarungsgemäß auf maximal 25 Frequenzen oder Kanalnummern begrenzt. Im Falle von Sendernetzen mit mehr als 25 Sendern, wie dies beispielsweise für das Sendernetz Bayern 3 zutrifft, läßt sich keine für alle Sender des Sendernetzes gemeinsame Liste aussenden; vielmehr muß jeder Sender oder jede Gruppe räumlich benachbarter Sender eine eigene Liste aussenden, welche maximal 25 Frequenzen enthalten darf. Die Schwierigkeit dabei liegt darin, daß infolge der Vielzahl von Ballstrecken in der Sendernetzstruktur innerhalb der öffentlichrechtlichen Rundfunkanstalten der Bundesrepublik Deutschland die vom Muttersender ausgesendete Liste für den Tochtersender u.U. nicht paßt; sie muß nach dem Ballempfänger ausgefiltert und durch die für den jeweiligen Tochtersender zutreffende Liste ersetzt werden. Diese Ausfilterung und Neueinspeisung ist mit erhöhtem Aufwand verbunden. Hinzu kommt, daß durch die Filterung auch die Qualität des Programmsignals verschlechtert wird. Bei Senderketten mit weniger als 25 Sendern wäre zwar die Aufnahme aller Senderfrequenzen in einer gemeinsamen Liste möglich, doch würde dies bei sehr vielen Senderfrequenzen zu entsprechend langen Einstellzeiten der Empfänger führen.

Die Aufgabe der Erfindung besteht demgegenüber darin, ein Verfahren der eingangs erwähnten Art anzugeben, bei welchem eine Filterung und Neueinspeisung der Liste alternativer Frequenzen vermieden und in der Regel eine relativ kurze Einstellzeit der Empfänger gewährleistet werden kann. Diese Aufgabe wird erfindungsgemäß durch die kennzeichnenden Merkmale des Patentanspruchs gelöst.

Bei dem erfindungsgemäßen Verfahren strahlt jeder Sender nicht nur seine eigene Liste, sondern sequentiell auch die Listen aller weiteren Sender derselben Senderkette aus, wobei die Betriebsfrequenzen der einzelnen Sender jeweils am Anfang der einzelnen Listen stehen. Der Empfänger kann daher nach erfolgtem Empfang aller Listen aufgrund seiner momentanen Abstimmfrequenz die zu dem momentan eingestellten Sender gehörende Liste selektieren, indem er die Abstimmfrequenz mit der ersten Frequenz jeder Liste innerhalb der Listenfolge vergleicht. Eine Filterung und Neueinspeisung wird dadurch beim Ballempfang überflüssig. Ferner erkennt der Empfänger auch die alternativen Frequenzen, auf denen er bei Verlassen des Versorgungsbereichs des momentan eingestellten Senders das gleiche Programm weiter empfangen kann, ohne daß er die alternativen Frequenzen der übrigen Listen prüfen muß. Das Umschalten auf einen anderen Sender derselben Senderkette kann auf diese Weise in der Regel sehr rasch durchgeführt werden.

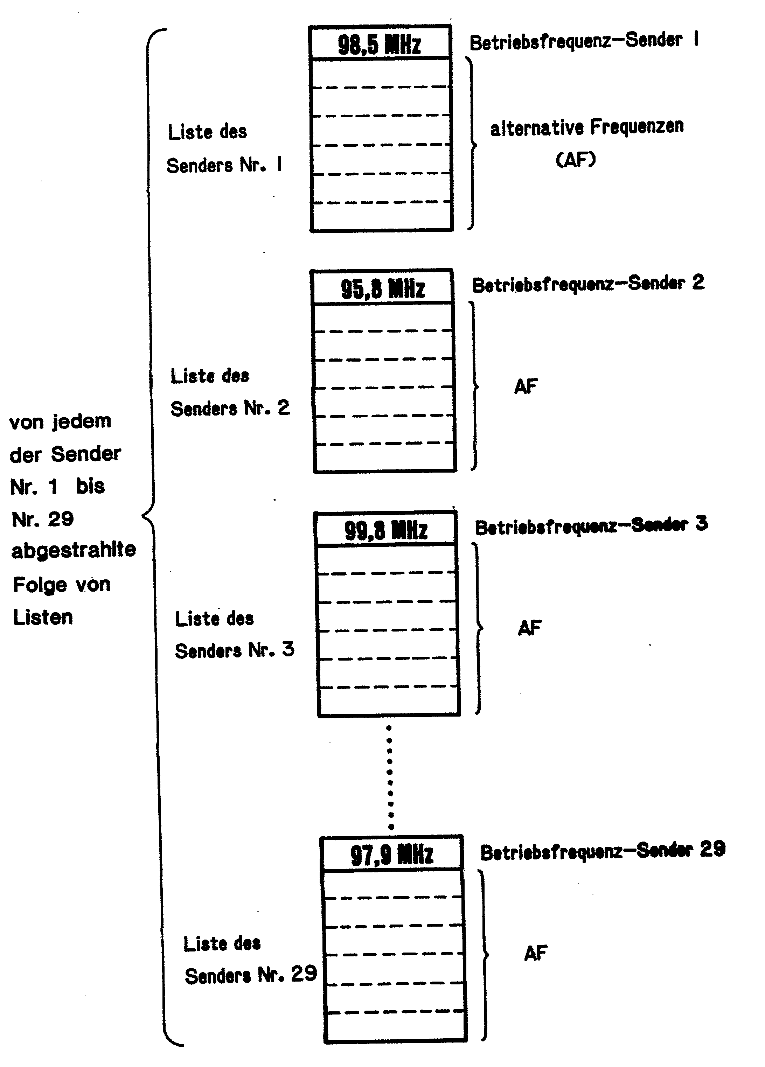

Die Erfindung wird anhand der Zeichnung näher erläutert, welche eine schematische Darstellung der von jedem Sender einer Senderkette abgestrahlten Folge von Listen alternativer Frequenzen zeigt. Im betrachteten Beispielsfall wird von einem Rundfunksignal ausgegangen, in welches ein Hilfsträger von 57 kHz eingefügt ist. Der Hilfsträger kann eine Amplitudenmodulation enthalten, welche eine Verkehrsfunkkennung zum Inhalt hat. Als Modulation bzw. als weitere Modulation ist dem Hilfsträger ein Datensignal aufgeprägt, welches in einer bestimmten, hier nicht näher interessierenden Weise codiert ist. Dieses Datensignal wird in übereinstimmender Form von sämtlichen Sendern einer Senderkette übertragen, beispielsweise von sämtlichen 29 Sendern der Senderkette "Bayern 3" im Versorgungsbereich des Bayerischen Rundfunks. Das übereinstimmend übertragene Datensignal enthält eine Folge von Listen alternativer Frequenzen für sämtliche Sender der Senderkette, im dargestellten Beispielsfall die Liste des Senders Nr.1, die Liste des Senders Nr.2, die Liste des Senders Nr.3 bis zur Liste des Senders Nr.29 für den Fall einer Senderkette mit 29 Sendern. Jede Liste ist auf den jeweiligen Sender speziell zugeschnitten und enthält entsprechend der Vereinbarung innerhalb der Europäischen Rundfunk-Union maximal 25 Frequenzen, im Regelfall jedoch erheblich weniger. Erfindungsgemäß steht am Beginn jeder Liste die Betriebsfrequenz des zugehörigen Senders, d.h., bei der Liste des Senders Nr.1 steht am Anfang die Betriebsfrequenz des Senders Nr.1, z.B. 98,5 MHz. Wie erwähnt, wird die dargestellte Folge von 29 Listen von jedem Sender der Senderkette als Datensignal übertragen.

Der Empfänger empfängt und decodiert das übertragene Datensignal, d.h., die Folge von Listen alternativer Frequenzen. Um die für den momentan abgestimmten Sender gültige Liste aus der empfangenen Listenfolge zu selektieren, braucht der Empfänger lediglich die erste Frequenz jeder Liste mit der momentanen Abstimmfrequenz zu vergleichen, was selbst bei 29 Listen in äußerst kurzer Zeit durchführbar ist. Diese Selektion kann entweder im On-Line-Betrieb oder im Off-Line-Betrieb erfolgen, d.h., ohne oder mit Zwischenspeicherung der empfangenen Folge von Listen. In jedem Falle wird die selektierte Liste gespeichert. Bei der Verarbeitung der empfangenen und ggf. zwischengespeicherten Folge von Listen selektiert der Empfänger diejenige Liste, deren erste Frequenz (gleich Betriebsfrequenz des zugeordneten Senders) mit der momentanen Abstimmfrequenz übereinstimmt. Stimmt die erste Frequenz mehrerer Listen mit der eingestellten

Betriebsfrequenz überein, so müssen alle diese Listen selektiert werden. Ausschließlich die selektierte(n) Liste(n) wird(werden) für die anschließende Optimierung der Abstimmung verwendet. Dieser Abstimmvorgang erfolgt entweder durch einen entsprechenden Befehl des Hörers oder automatisch, wenn beispielsweise der momentan empfangene Sender nicht mehr empfangswürdig ist. Bei dem Abstimmvorgang stimmt der Empfänger selbsttätig auf die in der(den) selektierten Liste(n) aufgeführten alternativen Frequenzen ab und selektiert diejenige alterntive Frequenz, welche den bestmöglichen Empfang bietet.

Mit Hilfe des erfindungsgemäß übertragenen Datensignals läßt sich auch bei Senderketten mit mehr als der festgelegten maximalen Anzahl von alternativen Frequenzen eine rasche Optimierung der Abstimmung mobiler Empfänger durchführen, ohne daß eine Ausfilterung und Neueinspeisung von Frequenzlisten am Standort von Tochtersendern erforderlich wird.

## Patentansprüche

1. Verfahren zum Übertragen einer digitalen Information innerhalb eines Rundfunksignals zur optimalen Abstimmung von mobilen Empfängern, wobei die digitale Information in bezug auf den das Rundfunksignal ausstrahlenden Rundfunksender die Betriebsfrequenzen von alternativ mit demselben Programminhalt empfangbaren Rundfunksendern in Form einer "Liste alternativer Frequenzen " (Frequenzliste) angibt, dadurch gekennzeichnet, daß in jeder Frequenzliste die Betriebsfrequenz des betreffenden Rundfunksenders den alternativen Frequenzen vorangestellt ist, so daß für einen mobilen Empfänger eine eindeutige Zuordnung zwischen den Betriebsfrequenzen von empfangenen Sendern und zugehörigen alternativen Frequenzen feststellbar ist, und daß alle für die einzelnen Rundfunksender mit gleichem Programminhalt in dieser Weise optimierten Frequenzlisten von jedem dieser Sender als Folge von Listen ausgestrahlt werden.

## Claims

1. A process for transfering digital information within a radio signal for optimum tuning of mobile receivers, wherein the digital information indicates, with respect to the radio transmitter emitting the radio signal, the operating frequencies of alternative radio transmitters which can be received with the same program content, in the form of a "list of alternate frequencies" (frequency list), characterised in that, in each frequency list, the operating frequency of the respective radio transmitter is put in front of the alternative frequencies so that, for a mobile receiver, a clear allocation of the operating frequencies of received transmitters to associated alternative frequencies can be established and in that all frequency lists which are optimized in this way for the individual radio transmitters with identical program content are emitted by each of these transmitters as a sequence of lists.

## Revendications

1. Procédé de transfert d'informations numériques au sein d'un signal radio, en vue d'un accord optimal de syntonisation de récepteurs mobiles, les informations numériques concernant l'émetteur radio qui diffuse le signal radio indiquant les fréquences de fonctionnement d'émetteurs radio pouvant, sous la forme d'une "liste de fréquences alternatives" (liste de fréquences), être reçus en substitution tout en ayant le même contenu de programme, procédé caractérisé en ce que, dans chaque liste de fréquences, la fréquence de fonctionnement de l'émetteur radio concerné est placée en tête par rapport aux fréquences alternatives de façon telle que, pour un récepteur mobile, on peut constater une relation claire entre les fréquences de fonctionnement des émetteurs reçus et les fréquences alternatives correspondantes; et en ce que, pour les émetteurs radio individuels comportant le même contenu de programme, toutes les listes de fréquences optimisées de cette manière sont diffusées par chaque émetteur sous la forme d'une succession de listes.

EP 0 294 511 B1